# EUROPEAN PATENT APPLICATION

(11) **EP 0 841 748 A2**
(43) Date of publication of application: **13.05.1998**
(21) Application number: 97308975.8
(22) Date of filing: 07.11.1997
(51) Int. Cl.: H03H 7/01

(54) **Electronic filter components incorporating capacitors**

(30) Priority: 09.11.1996 GB 9623460
(71) Applicant: OXLEY DEVELOPMENTS CO., LTD., Ulverston Cumbria LA12 9QG (GB)
(72) Inventor: Edwards, Geoffrey Stephen, Grange Over Sands, Cumbria, LA11 7QB (GB); Bell, Andrew John, Grange Over Sands, Cumbria, LA11 7BX (GB); Thomlinson, Martin Paul, Grange Over Sands, Cumbria, LA11 7DP (GB)
(74) Representative: W.P. Thompson & Co.

(57) **Abstract**

An electronic filter device comprising one or more inductors integrated as an additional layer or layers in a multi-layer capacitor to form a single monolithic component. The inductor(s) comprise one or more conducting inductor tracks (62) disposed on covered by, or embedded within a layer (60) of a high magnetic permeability material, preferably a ferrite.

## Description

The present invention relates to electronic filter components incorporating capacitors.

In modern electronic circuitry there is an increasing need for the miniaturisation of discrete electronic components such as filters, which incorporate one or more capacitors within their structure.

Electronic filters generally comprise a combination of one or more filters and inductors connected together in accordance with well known rules to provide the required filtering action. In conventional filters of this type it has been the practice to use discrete capacitors and inductors combined together to form the necessary filter structure. However, such filters are bulky and space-consuming and it would be advantageous if their size could be reduced.

It is known to fabricate capacitors using layers of a particular ceramic material, which layers are co-fired with two or more spaced electrodes to build up the required capacitor structure in a monolithic format. Such capacitors are known as multi-layer capacitors.

In accordance with the present invention, one or more inductors are integrated as an additional layer or layers in a multi-layer capacitor to form a single monolithic component.

Preferably, the inductor(s) comprises one or more conducting inductor tracks disposed on, covered by or embedded within a layer of a high magnetic permeability material.

For example the inductor track(s) may be of silver, gold, platinum etc in accordance with usual conductor printing techniques.

Preferably the high magnetic permeability material is a ferrite.

A preferred Pi-section surface mount filter comprises two multi-layer capacitors fashioned from the same block of ceramic, outer electrodes of the two capacitors being coupled by a conducting inductor track which is embedded within a layer of ferrite formed integrally with said ceramic block and contributing to the overall inductive part of the filter and these outer electrodes also being coupled to respective terminations of the filter.

A preferred T-section surface mount filter comprises a single multi-layer capacitor fashioned from a single block of ceramic, one electrode of the capacitor being connected to the junction of two series connected, conducting inductor tracks which are embedded within a layer of ferrite formed integrally with said ceramic block and contributing to the overall inductive part of the filter, the free ends of the inductor tracks being connected to respective terminations of the filter.

A preferred L-C section surface mount filter comprises a single multi-layer capacitor fashioned from a single block of ceramic, one electrode of the capacitor being connected to one end of a conducting inductor track which is embedded within a layer of ferrite formed integrally with said ceramic block and contributing to the overall inductive part of the filter, the two ends of the inductor track being connected to respective terminations of the filter.

In each case, the presence of the ferrite around the conducting inductor track has the effect of increasing the inductance of the conducting inductor track and thereby enabling the overall size of the monolithic block to be reduced.

Many ways can be adopted for making the ferrite integral with the underlying chip capacitor. Our preferred method is for high temperature glass bonding but it could also simply be glued together or the ferrite screen printed onto fired ceramic and then fired using conventional thick film technology.

The invention is described further hereinafter, by way of example only, with reference to accompanying drawings, in which:
FIG. 1 is a diagrammatic view of a first embodiment of multi-layer device in accordance with the present invention in the form of a Pi-section filter;
FIG. 2 is a cross-sectional view along the line X-X of FIG. 1;
FIG. 3 is a cross-sectional view along the line Y-Y of FIG. 1;
FIG. 4 is a cross-sectional view along the line Z-Z of FIG. 1;
FIG. 5 is an equivalent circuit of the device of FIG. 1;
FIG. 6 is an exploded view of a second embodiment of a surface mount Pi-section filter in accordance with the present invention;
FIG. 7 is a diagrammatic perspective view of the device of FIG. 6;
FIG. 8 shows the electrode configuration in the device of FIGS. 6 and 7;
FIG. 9 is an equivalent circuit of the device of FIGS. 6-8;
FIG. 10 is a diagrammatic side view of one side of a T-section surface mount filter in accordance with the present invention.
FIG. 11 is a top view of the device of Fig. 10;
FIG. 12 is a diagrammatic side view of the device of FIG. 6 from the other side;
FIG. 13 is an internal view of the device of FIG. 10;
FIG. 14 is an equivalent circuit diagram of the device of FIGS. 10-13;
FIG. 15 is a diagrammatic side view of an L-C section surface mount filter in accordance with this invention;
FIG. 16 is a top view of the device of FIG.15;
FIG. 17 is an internal view of the device of FIG. 15; and
FIG. 18 is an equivalent circuit of the device of FIGS. 15-17.

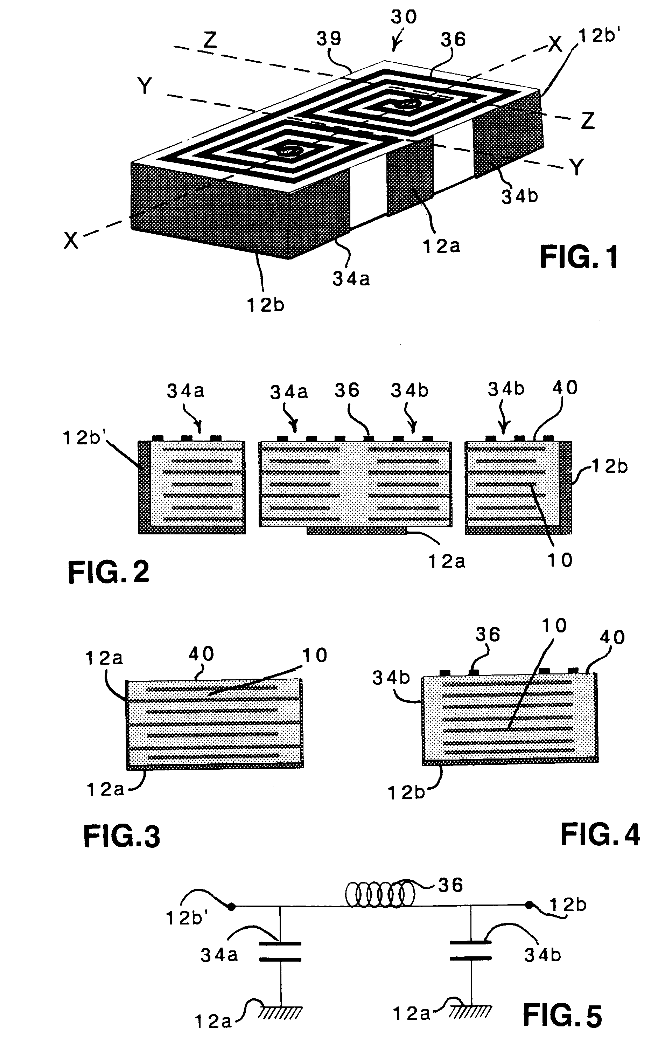

Referring first to Figs. 1 to 5, there is shown a Pi-section surface mount, radio frequency interference suppression filter 30 comprising two discoidal, multi-component, multi-layer capacitors 34a, 34b. The capacitors 34a, 34b are fashioned from the same block of ceramic. The internal, external and hole electrodes are arranged such that the two end terminations 12b, 12b' are linked by the inductance of a conducting double spiral 36 on the upper surface of the component. The capacitor 34b is connected between an earth terminal 12a and end termination 12b, and the capacitor 34a is connected between the earth terminal 12a and the end termination 12b'. An equivalent circuit is illustrated in Fig. 5.

The surface 39 is provided with a high magnetic permeability layer 40 of a ferrite. In the drawings the ferrite layer 40 is shown as being underneath the conducting spiral 36. However, in other embodiments it may be above the spiral 36 or, most preferably, the conducting spiral is disposed within a thicker layer of ferrite as in the other embodiments described hereinafter.

The presence of the high magnetic permeability ferrite has the advantageous effect of increasing the inductance of the spiral conductor.

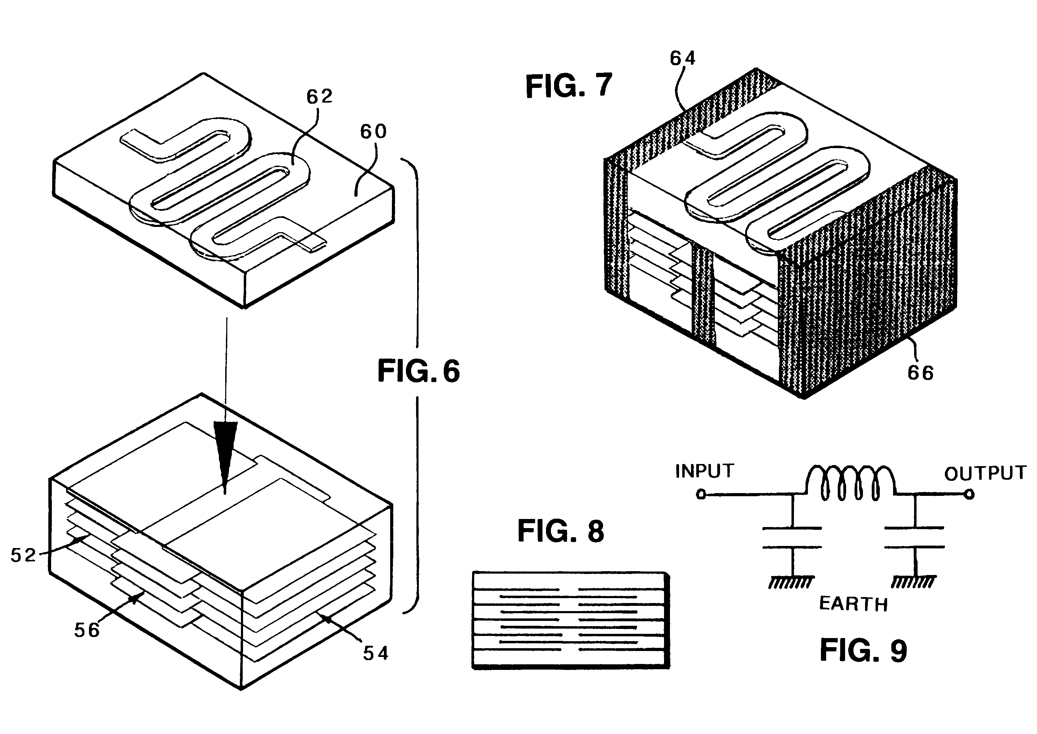

Referring now to Figs 6 to 10, there is shown a second embodiment of a surface mount, Pi-section filter comprising a twin multi-layer capacitor formed from three sets of electrodes 52, 54, 56. The central electrode stack 56 forms the earth connection whilst the two outer electrode stacks 52,54 provide the through line connections. An inductor 56 which connects the two outer electrode stacks 52,54 is formed by the printing of thick films of a paramagnetic ferrite material 60 and a silver conductor 62 in various configurations, an example of which is shown in the figures. The silver conducting track(s) 62 should be totally enclosed by the ferrite material 60 and forms the through line connection having an inductance enhanced by the presence of the ferrite material 60. The inductor and twin capacitor are joined as shown by an appropriate adhesive, which could be a high temperature adhesive or epoxy or a ceramic to ceramic glass seal. End terminations 64, 66 are then applied to the two component chip either by electroplating or by firing on an appropriate cermet composition.

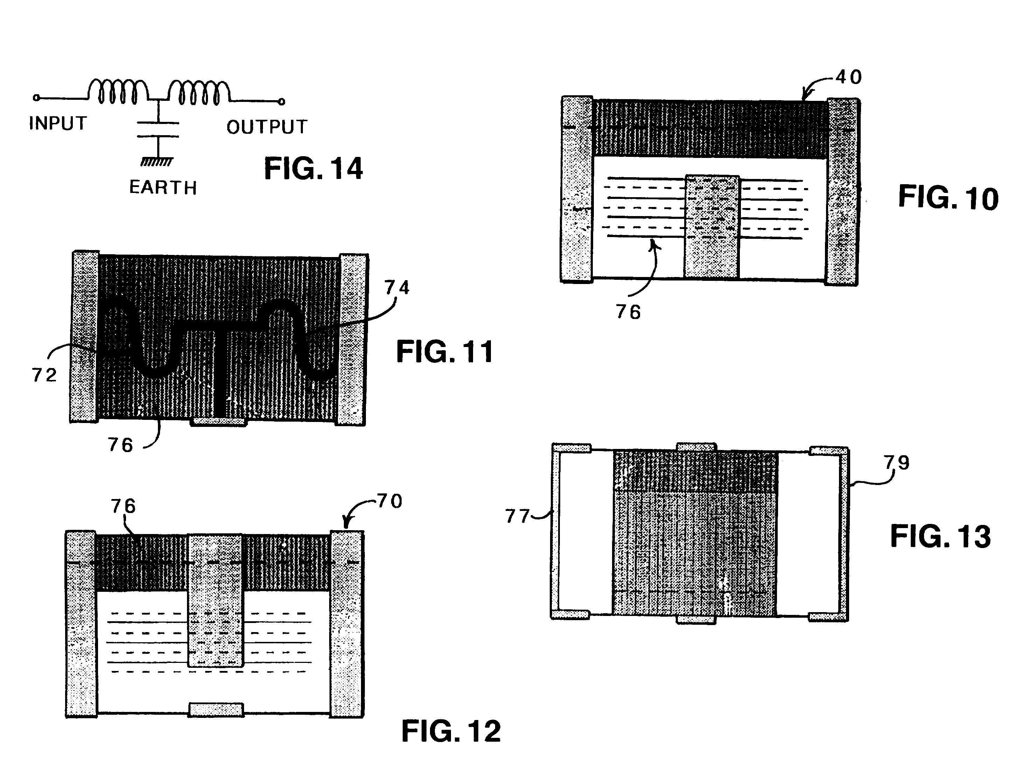

Referring now to Figs. 10 to 14, there is shown a T-section surface mount filter 70 wherein two inductors 72,74 and a single multi-layer capacitor 76 are produced in the same manner as the structure of Figs. 6 to 10. Again, both inductors are embedded in a ferrite layer 76.

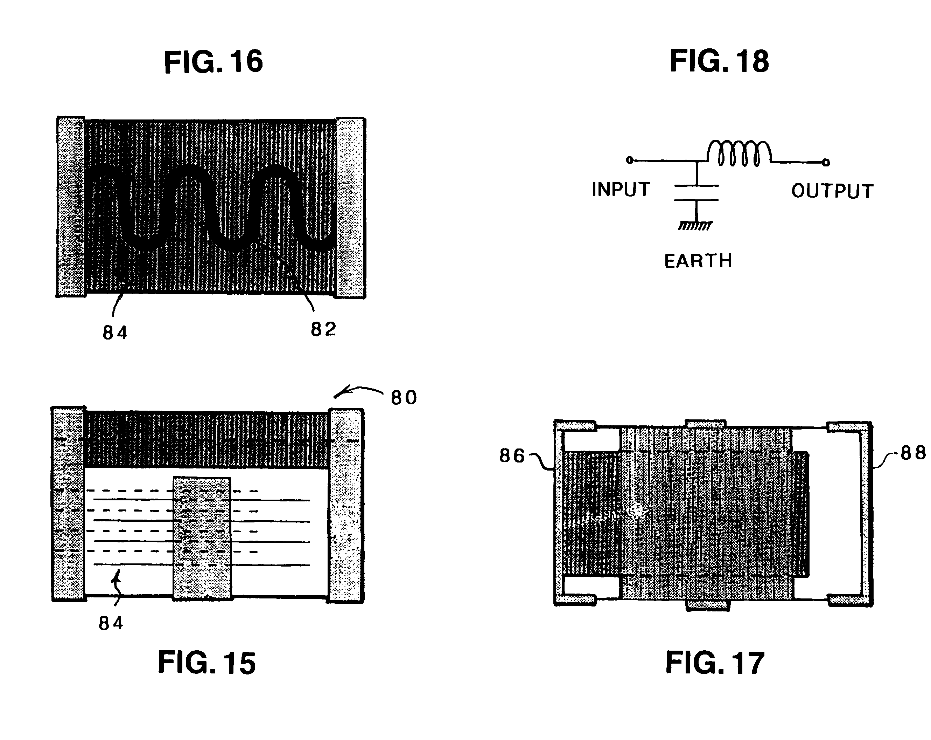

Referring next to Figs 16 to 18, there is shown an L-C section surface mount filter 80 which is formed in a similar manner to the filter of Figs 6 to 10 using the superposition of a single chip inductor 82 and a single capacitor 84 in which the two electrode stacks emerge along adjacent edges of the component as shown in Figures 11 -13.

The aforegoing structures provide the advantage of enabling the interaction of ferrite inductors with multi-layer capacitors of various geometries in a single monolithic component. The multi-layer capacitors may if desired be formed using the MCMLS (multi-layer, multi-composition) concept described in our copending Application No. based on GB 9623460.4, although this is not necessary to the present invention.

The integration of the ferrite inductor as an additional integral layer or layer to the monolithic capacitor results in RF filters which are smaller, more compact, and surface mount compatible in comparison with filter fabricated from two or more discrete components.

## Claims

1. An electronic filter device, characterised by one or more inductors (62) integrated as an additional layer or layers (60) in a multi-layer capacitor to form a single monolithic component.

2. An electronic filter device as claimed in claim 1, wherein the inductor(s) comprises one or more conducting inductor tracks disposed on, covered by, or embedded within a layer of a high magnetic permeability material.

3. An electronic filter device as claimed in claim 2, wherein said high magnetic permeability material is a ferrite.

4. An electronic filter device as claimed in claim 3 in the form of a Pi-section surface mount filter and comprising two multi-layer capacitors fashioned from the same block of ceramic, outer electrodes (52,54) of the two capacitors being coupled by a conducting inductor track (62) which is embedded within a layer (60) of ferrite formed integrally with said ceramic block and contributing to the overall inductive part of the filter device and these outer electrodes also being coupled to respective terminations (64,66) of the filter device.

5. An electronic filter device as claimed in claim 3 in the form of a T-section surface mount filter and comprising a single multi-layer capacitor fashioned from a single block of ceramic, one electrode of the capacitor being connected to the junction of two series connected, conducting inductor tracks (72,74) which are embedded within a layer (75) of ferrite formed integrally with said ceramic block and contributing to the overall inductive part of the filter device, the free ends of the inductor tracks (72,74) being connected to respective terminations (77,79) of the filter.

6. An electronic filter device as claimed in claim 3 in the form of an L-C section surface mount filter and comprising a single multi-layer capacitor fashioned from a single block of ceramic, one electrode of the capacitor being connected to one end of a conducting inductor track (82) which is embedded within a layer (84) of ferrite formed integrally with said ceramic block and contributing to the overall inductive part of the filter device, the two ends of the inductor track (82) being connected to respective terminations (86,88) of the filter device.
